# EUROPEAN PATENT SPECIFICATION

(11) **EP 0 457 851 B1**
(45) Date of publication and mention of the grant of the patent: **27.12.1995**
(21) Application number: 90905918.0
(22) Date of filing: 08.02.1990
(51) Int. Cl.: C04B 35/00, C01G 3/02, H01L 39/24

(54) **ORIENTED GRAINED Y-Ba-Cu-O SUPERCONDUCTORS HAVING HIGH CRITICAL CURRENTS AND METHOD FOR PRODUCING SAME**
YTTRIUM-BARIUM-KUPFER-SAUERSTOFF-SUPRALEITER MIT GERICHTETEN KRISTALLITEN UND HOHER KRITISCHER STROMDICHTE SOWIE VERFAHREN ZUR IHRER HERSTELLUNG
SUPRACONDUCTEURS Y-Ba-Cu-O A GRAINS ORIENTES AYANT DES COURANTS CRITIQUES ELEVES ET LEUR PROCEDE DE FABRICATION

(30) Priority: 10.02.1989 US 309382
(43) Date of publication of application: 27.11.1991
(73) Proprietor: UNIVERSITY OF HOUSTON, Houston, Texas 77004 (US)
(72) Inventor: SALAMA, K. University of Houston-University Park, 4800 Calhoun Drive Houston, TX 77004 (US); SELVAMANICKAM, V. University of Houston, 4800 Calhoun Drive Houston, TX 77004 (US)
(74) Representative: Jones, Michael Raymond
(86) International application number: PCT/US90/00739
(87) International publication number: WO 90/09344

(56) References cited:
- US-A- 4 824 826
- US-A- 4 892 861
- Applied Physics Letters, Vol 52(26), 27 June 1988, SEKINE et al., "Fabrication of multifilamentary Y-Ba-Cu-O oxide superconductors", pages 2261-2.
- Journal Electrochemical society, October 1987, YUREK et al., "Direct Synthesis of a metal/superconducting Oxide Composite by Oxidation of a Metallic Precursor", pages 2635-6.
- Japanese Journal of Applied Physics, Vol.26(12), December 1987, KATAYAMA- YOSHDA, "Growth of YBazCuzOzx single crystals", pages L2007-9.
- Japanese Journal of Applied Physics, Vol. 26(5), May 1987 TAJIMA et al., "Composition dependence of the Physical Properies in the superconducting Y-Ba- Cu-O System", pages L845-7.
- Japanese Journal of Applied Physics, Vol. 27(2), February 1988, KUMAKURA et al. , Large Magnetization in YBazCuzO7 prepared by sintering at High-Temperature", pages L 188-90.
- Applied Physics Letters Vol. 51(12), 21 September 1987, NARAYAN et al., "Microstructure and properties of YBa2Cu309-x superductors with transitions at 90 and near 290 K", pages 940-2.
- Nature, Vol. 334, 28 July 1988, SATCHELL et al., "High-magnetic-field critical currents in thin films of YBazCu3O7", pages 331-3.
- Journal of American Ceramic Society, Vol. 71(11), November 1988, PETERSON et al., "Magnetic Field Inducement of Tecture in BazYCU3O6.9 Particle Assemblies under Cryogenic Conditions", pages 458-9.
- Applied Physics A Vol. 47, September 1988, FERREIRA et al., "Magnetic Field alignment of High-Tc Superconductors RBazCU3O7-X (R=rare earth)", pages 105-10.
- Physical Review letters, Vol. 58(25), 22 June 1987, CHAUDHARI et al., Critical- Current Measurements in epitaxial films of YBazCu3O7-x Compounds", pages 2684-6
- Material Research Society Symposium Proceedings Vol. 99, November-December 1987, TAYLOR et al., "Sintering time and temperature for BazYCu3O7-x superconductors ", pages 663 - 666.
- Physical Review B Vol. 37 (16), 1 June 1988, MARSHALL et al., "Ordered - defeat structure in epitaxial YBa2Cu3O7-x thin films", pages 9353-8.

## Description

### Background of the Invention

The most distinctive property of a superconductive material is the near total loss of electrical resistance by the material when at or below a critical temperature. This critical temperature is characteristic of the material and is referred to as the superconducting transition temperature of the material, T_{c}.

The history of research into the superconductivity of specific materials began with the discovery in 1911 that mercury superconducts at a transition temperature of about 4°K. In the 1920's NbC was found to superconduct at a higher temperature, namely up to about 10.5°K. Since that time, many applications for the phenomena of superconductivity have been conceived which could not be commercialized because of the extreme low transition temperatures of the superconductive material.

Although many materials have been examined in an effort to find compounds which will superconduct at higher, more practical temperatures, the highest temperature superconductor known until about 1986 was Nb₃Ge having a critical temperature, Tc, of approximately 23.3°K. Superconducting devices utilizing Nb₃Ge as the superconductor, like those devices which employed the superconductors preceding Nb₃Ge, required the use of liquid helium as refrigerant-coolant in commercial applications. In 1986 Bednorz and Muller disclosed that certain mixed phase compositions of La-Ba-Cu-O appeared to exhibit superconductivity at about 30°K. Investigation of that system established that the crystalline phase therein responsible for superconductivity had a crystal structure like that of K₂NiF₄ (214). The upper temperature limit of onset, T_{co}, for superconductors of a 214 type crystalline structure has been found to be about 48°K.

Following the discovery of superconductivity in such rare earth-alkaline earth Cu oxide systems of a 214 crystalline structure, a new class of rare earth-alkaline earth-copper oxides was discovered which were superconductive at temperatures above 77°K. This new class of rare earth-alkaline earth-copper oxides, commonly referred to as "123" high-temperature superconductors, have perovskite related crystalline structures. The unit cell consists of three sub-cells stacked one above the other along the C-axis. X-ray crystallographic and neutron powder diffraction studies indicate the structure to be oxygen deficient and that the ordering of oxygen in the basal planes is critical to the oxide exhibiting superconductivity properties. See C. Poole et al, Copper Oxide Superconductors (John Wiley & Sons 1988). The unit cell formula of the 1,2,3 compound is

L₁M₂Cu₃O₆+δ (δ = 0.1 to 1.0, preferably about 1.0)

wherein L is scandium, yttrium, lanthanum, cerium, praseodymium, neodymium, samarium, europium, gadolinium, terbium, dysprosium, holmium, erbium, thulium, ytterbium, and lutetium, and M is barium, strontium or mixtures thereof. The studies indicate that when δ is between about 0.1 to about 0.5, the resulting 1,2,3 compound exhibits a tetragonal unit cell crystallographic symmetry and is non-superconductive. In this unit cell, the lattice dimensions of the C-axis is approximately 11.94 angstroms and the a and b axes are approximately 3.9 angstroms. When δ is between 0.5 and 1.0, the resulting 1,2,3 compound has an orthorhombic unit cell crystallographic symmetry and is superconductive. The orientation of the oxygen atoms in the unit cell causes the cell to compress slightly along the a axis and thus the lattice dimension of the a axis is less than that of the b axis. Lattice constants a = 3.80, b = 3.86 and c = 11.55 have been reported for the orthorhombic unit cell.

With the discovery of the 123 class of high temperature superconductivity compositions it has become possible to economically pursue many previously conceived applications of the superconductivity phenomena which were commercially impractical wherein cooling by liquid helium was required. Since they superconduct at temperatures greater than 77°K, the new "123" class of high temperature superconductors may in practical applications be cooled with liquid nitrogen--a more economically feasible refrigerant. As a result, the rather complex thermal insulation and helium-recycling systems employed with conventional superconductors, in order to avoid wasting the expensive helium coolant, has been abandoned, thereby greatly simplifying and enhancing the reliability of commercial superconductors.

However, the heretofore high temperature superconductors have been impractical in some applications due to their inability to (1) carry high current loads in intense magnetic fields, (2) entrap strong magnetic fields, and (3) exhibit low high-frequency surface resistance. As a result, significant commercial barriers against use of the 123 superconductors in numerous applications, such as in magnets, magnetic separators, transmission lines, high frequency generators and magnetically levitating trains (meglav) exist.

In magnetic separators, for example, superconductors are required to have a current density, J, between about 33,000 and 66,000 amps/cm² in a magnetic field between 2 and 3 T. In order to be commercially practical in transmission lines and high frequency generators, the superconductive material must further exhibit a very small high frequency surface resistance at or below its critical temperature. To be practical in magnets, superconductive materials must, in addition to being lightweight, be capable of entrapping within their crystalline structure a high magnetic field. [While superconductive materials of low T_{c} are reported as being capable of entrapping fields as high as 22,400 Gauss (see, for example, M. Rabinowitz, E.L. Garwin and D.J. Frankel, Lettere Al Nuovo Cimento, 7, 1, (1973); E.L. Garwin, M. Rabinowitz, and D.J. Frankel, Appl. Phys. Lett., 22, 599 (1973); M. Rabinowitz, H.W. Arrowsmith and S.D. Dahlgren, Appl. Phys. Lett., 30, 607 (1977); and M. Rabinowitz, IEEE Magnetics, 11, 548 (1975)), such superconductors are not commercially viable for use in magnets due to their low T_{c} as well as their inability to carry high current loads.]

### Summary of the Invention

The invention comprises a 123 high temperature superconductor material having a current density, J, of from about 30,000 to about 85,000 amps/cm² at zero magnetic field and 77°K. Such superconductive materials are characterized by a T_{c} of at least 77°K and are capable of entrapping a magnetic field Bₜ, when placed in an external magnetic field of 0.8T (8000 Gauss), of at least 0.08T (800 Gauss). At 60°K, the superconductive material of this invention is further defined by a surface resistance in the a-b crystallographic plane at 98 GHz of less than about 6 milliohms. The preferred 123 superconductor is L₁Ba₂Cu₃O₆+δ wherein L is yttrium. Such superconductors are produced by a liquid phase process which comprises compacting the bulk product, L₁Ba₂Cu₃O, and then sintering the product at a temperature between about 40°C to about 90°C below its melting point, i.e., for Y₁Ba₂Cu₃O₆+δ at a temperature of approximately 940°C. The composition is then heated in a preheated chamber maintained at approximately about 80°C to about 190°C above the melting point of the 1, 2, 3 superconductor, generally about 1,090°C to about 1,200°C (approximately 1,100°C for Y₁Ba₂Cu₃O₆+δ) until it has been decomposed and partially melted and is then rapidly cooled to a temperature about 10°C to about 40°C above its melting point, i.e. for Y₁Ba₂Cu₃O₆+δ a temperature of about 1030°C and then is cooled at a controlled rate of 1°C/hr until it reaches a temperature of approximately 20°C to 40°C below its melting point, i.e., for Y₁Ba₂Cu₃O₆+δ a temperature of about 980°C. During this process, the grains comprising the material are formed and grown in length approximately 10,000 to 15,000 »m. The material is steadily held at 980°C for at least eight hours in order to complete the resolidification process. The material is then cooled to a temperature of approximately 400°C below its melting point (for Y₁Ba₂Cu₃O₆+δ approximately a temperature of about 600°C). The material is then slowly cooled by about another 200°C and is then annealed in oxygen.

### Brief Description of the Drawings

Figure 1 is 300 times magnification of a scanning electron microscope picture of the top surface of a Y₁Ba₂Cu₃O₆+δ composition of this invention as prepared according to Example 1.

Figure 2 is a 150 times magnification of a scanning electron microscope picture of a Y₁Ba₂Cu₃O₆+δ composition prepared in accordance with Example 1.

Figure 3 is an optical photomicrograph of 40 times magnification of a Y₁Ba₂Cu₃O₆+δ composition of this invention as prepared according to Example 1.

Figure 4 represents the configuration of the rf induced current flowing in the oriented grain sample, as set forth in Example 4.

Figure 5 demonstrates the surface impedance (y-axis) of the grain-oriented superconductors of this invention at temperatures (x-axis) at 98 GHz at the a-c and a-b planes.

### Detailed Description of the Preferred Embodiments

Superconducting compositions of this invention comprise an oxide complex defined by the formula:

L₁Ba₂Cu₃O₆+δ

wherein L is a rare earth element, i.e. scandium, yttrium, lanthanum, cerium, praseodymium, neodymium, samarium, europium, gadolinium, terbium, dysprosium, holmium, erbium, thulium, ytterbium, and lutetium, and δ has a number value of from about 0.1 to about 1.0. Preferably L is yttrium. Most preferably, δ is between about 0.5 to about 1.0. Such compositions are characterized by attainment of a zero resistance state at a transition temperature, T_{c1}, of 77°K or higher. When prepared in accordance with the process of this invention, such oxide complexes exhibit a J, (defined as the amount of current carried by a 1 cm² cross-section of material) in zero magnetic field at 77°K, of from about 30,000 to about 85,000 amps/cm². Generally, the J of the oxide complexes of this invention are greater than 70,000 amps/cm². At 77°K and an applied magnetic field of 0.6 T, the composition of this invention exhibits a J in excess of 37,000 amps/cm². Further, at 77°K and zero magnetic field, the composition of this invention exhibits a D.C. current density in excess of 18,500 amps/cm².

The oxide complexes of this invention are comprised of plate shaped grains having a length between approximately 10 mm to about 15 mm; an average width between about 5 mm to about 10 mm; and an average thickness between about 16 »m to about 20 »m. Such plate shaped grains may be stacked parallel to each other in the a-b crystallographic basal plane of the superconductor. The thickness off the stacked plate shaped grains is generally between 2 and 3 mm. The shape, length and orientation of the grains are primarily responsible for the dense structure of the oxide and its enhanced conductivity.

In addition to exhibiting high current densities, the oxide complexes of this invention are further capable of entrapping magnetic fields of a much higher magnitude than those entrapped by the high temperature superconductors of the prior art. As a result, the superconductors of this invention have particular applicability as magnets. Magnetic fields, Bₜ, in excess of 0.1T (1000 Gauss), even in excess of 0.12T (1200 Gauss), and as high as 0.128T (1280 Gauss) have been trapped in the oriented grain oxide complexes of this invention subsequent to the application of an external applied magnetic field of approximately 0.8T (8,000 Gauss) to the oxide complexes. The oxide complexes of this invention are capable of maintaining superconductive properties when exposed to an external magnetic field in excess of 30T (300,000 Gauss) at 77°K. Such oxides are especially valuable therefore in the production of magnets.

When the oxides of this invention are fabricated into cylinders of a 2 cm internal diameter and an external magnetic field is applied, such as approximately 0.8T (8,000 Gauss), an entrapped field of approximately 0.6T (6,000 Gauss) can be obtained.

A magnetic field can be entrapped in the superconductive material of this invention by various methods. In one method, referred to as field cooling, the superconductive material is placed into an existing magnetic field at a temperature in excess of its transition temperature, T_{c}. Room temperature is sufficient. The sample is then cooled to its transition temperature. In the second method, referred to as zero field cooling, the sample is first cooled to its transition temperature. A field of the magnitude equal to or slightly exceeding that of the critical field for the oxide, H_{c}, is then applied. The portion of the magnetic field, Bₜ, remaining trapped inside the sample is maintained within the superconductive material by persistent microscopic vortex currents. The entrapped magnetic field in the sample is measured by a Hall probe placed either adjacent to the sample or non-contiguously to the center of the sample.

The methods can be used with the oriented grain bulk material as well as the fabricated cylinders discussed herein.

The oriented grain oxides of this invention are further characterized by a lower microwave surface impedance than the superconductors of the prior art. The surface impedance can be determined by clamping a polished sample to the bottom of a TE₀₁₁ mode cylindrical resonant cavity and measuring the temperature dependence of the width of the cavity mode. The measurements are repeated with a copper end plate and the surface impedance is reported relative to that of copper. Such measurements are indicative of the high-frequency surface resistance and thus indicate the usefulness of the superconductors of this invention in the high frequency communication industry.

Measurements of surface resistance in the a-b basal plane of the aligned oriented oxide grains of this invention at 98 GHz is approximately 5-6 milliohms at or below 60°K. This value is to be compared to about 2000 milliohms at the same frequency and temperature for a sintered 123 material of the prior art. This value was obtained by extrapolation from measurements performed at 77° and 10 GHz. See, W. Kennedy et al, "Frequency Dependence of the Microwave Surface Resistance of Ceramic Y₁Ba₂Cu₃Oy", Solid State Communications, Vol. 70, No. 7, pp. 741-744, 1989.

The present invention also provides a process for producing the superconductive oxide complexes. Methods of preparing bulk samples containing L, Ba, Cu and O in amounts sufficient to render superconductivity are well known in the art. Such processes include, but are not limited to, solid-state, co-precipitation, and sol-gel techniques. In the solid state process, for example, selected amounts of solid powdered compounds containing barium, copper, oxygen and preferably yttrium, are thoroughly mixed and heated in order to complete a solid state reaction. When the desired complex is of the Y₁Ba₂Cu₃O₆+δ for example, the complex may be derived from 15 wt. % Y₂O₃, 53 wt. % BaCO₃, and 32 wt. % CuO. The solid powder compounds are preferably mixed in an intensive mixer, such as a jar mill or, more preferably, a ball mill. The mixture is then heated in air at a temperature of between about 920°C to about 960°C for a time sufficient to react the mixture in the solid state. When "L" in the above 123 formula is yttrium, the composition is preferably heated to approximately 920 to 940°C. Normally, the mixture is kept at this target temperature for approximately 24 hours. The sample is then cooled, preferably by rapidly quenching to approximately room temperature in air or an inert gas atmosphere.

In the process of this invention the bulk mass comprising L, Ba, Cu and O (in amounts sufficient to render a compound of the formula L₁Ba₂Cu₃O₆+δ) is first compressed by applying pressure to the sample. Normally pressures, generally between about 6 x 10⁶ kg/m² (9000 psi) to about 8 x 10⁶ kg/m² (11,000 psi), are required until the particles are held together to form a bulk material. When L is yttrium, the pressure is approximately 7 x 10⁶ kg/m² (10,000 psi). The compaction process preferably renders bars having dimensions approximating 6 to 24 mm x 4 to 16 mm x 30 to 65 mm. Such bars ensure a more uniform distribution of heat within the complex and further assists in the attainment of the desired length of the grains.

The compacted powder is then sintered, preferably in air, at a pressure between about 0 to about 2 kilobars and at a temperature of approximately 40°C to about 90°C below its melting point. When L is yttrium, for example, the mass is heated to from about 920°C to about 960°C for approximately 24 hours.

The preferred bars are partially sliced, preferably prior to heating, to a thickness of approximately 1.25 mm. to about 2.5 mm. Such slicing is preferably achieved with a diamond saw.

The sintered product is then decomposed by heating it for the appropriate time, generally about 6 to about 12 minutes, in a chamber preheated to a temperature approximately 80°C to about 190°C above the melting point of the solid product, generally from about 1090°C to 1200°C. By rapid heating of the sample (about 20s) beyond the peritectic temperature, formation of low temperature eutectics is avoided. When the oxide is Y₁Ba₂Cu₃O₆+δ the mass is heated at a temperature of approximately 1100°C for approximately 8 to 12 minutes, most preferably ten minutes, where the 123 phase melts incongruently into Y₂BaCuO₅ and a liquid phase.

The sample is then cooled in two distinct phases. In the first phase, the entire composition is rapidly cooled to a temperature approximately 10°C to 40°C above the melting point of material, generally between about 1010°C to about 1040°C. When L is yttrium, the molten composition is rapidly cooled to 1030°C in less than about five minutes. In the second phase, the composition is slowly cooled, such that it undergoes peritetic transformation, at a rate of approximately 1°C per hour until the steady state temperature, approximately 20°C to about 40°C, below the melting point of the oxide is attained. The steady state temperature is generally between about 960°C to about 1000°C. While cooling slowly through the peritectic temperature, the decomposed phases react to form the 1-2-3 phase. In this process, no thermal gradient exists in the sample and the whole sample uniformly solidifies at a slow rate through the peritectic point. When L is yttrium, the composition is cooled generally by 1°C per hour over 50 hours from about 1030°C to about 980°C. Such a cooling rate is primarily responsible for the formation and positioning of the superconductor grains nearly parallel to one another. During this cooling the grains grow to a length of approximately 10,000 to approximately 15,000 micrometers. The specimen is maintained at the steady state temperature for a time sufficient to complete the solidification process. For a Y₁Ba₂Cu₃O₆+δ oxide complex, the sample is held at 980°C for approximately eight hours for the completion of solidification.

The sample is then further cooled at a rate such that the formation of microcracks is minimized. This is generally achieved by cooling the grains in air to approximately 400°C below its melting point at the rate of approximately 60°C per hour. In a Y₁Ba₂Cu₃O₆+δ composition, for example, the specimen is cooled from 980°C to approximately between 550°C to about 650°C in approximately 5.5 to about 6.5 hours. Such gradient cooling renders little disruption, if any, to the near-parallel orientation of the grains.

The transformation of the crystal lattice of the complex from a non-superconductive state to a superconductive state, wherein the orthorhombicity of the crystal lattice is maximized, is achieved by subsequently cooling the complex in air to a temperature approximately 600°C below its melting point. The rate of cooling is approximately 30°C per hour. In a Y₁Ba₂Cu₃O₆+δ composition, the complex is transformed to its superconductive state by cooling it to approximately 380°C to about 420°C from approximately 550°C to about 650°C in approximately six and a half hours.

The requisite amount of oxygen to obtain a formula of L₁Ba₂Cu₃O₆+δ is then diffused into the orthorhombic grains by annealing it in an oxygen-containing atmosphere for sufficient time. The resulting crystal having a perovskite structure.

Preferably, the annealing step of the process of this invention is comprised of three distinct stages. All of the stages proceed in the presence of oxygen. In the first stage, the sample is heated for approximately 11 to 13 hours at a temperature of approximately 580°C to approximately 620°C. In the second stage, the sample is annealed at a temperature approximately 100° less than the first stage, i.e., approximately 480°C to approximately 520°C for the same period of time. In the last stage, the sample is annealed at a temperature of approximately 380°C to approximately 420°C for approximately 11 to 13 hours. Such a three stage annealing step increases the diffusion of oxygen into the complex, thereby enhancing the formation of the orthorhombic state.

The process of this invention permits the manufacture of superconductive materials of significantly greater dimensions and volumetric size than products produced by the processes of the prior art. Further, superconductive oxides of a given volumetric size are produced in a fraction of the time under this process than under the processes of the prior art. For example, under the preferred embodiments of this invention, a superconductive material with a volume in excess of 6500 mm³ can be prepared in approximately 130 hours.

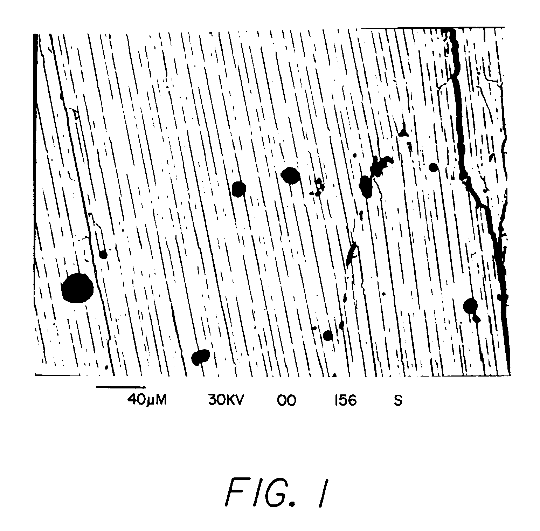

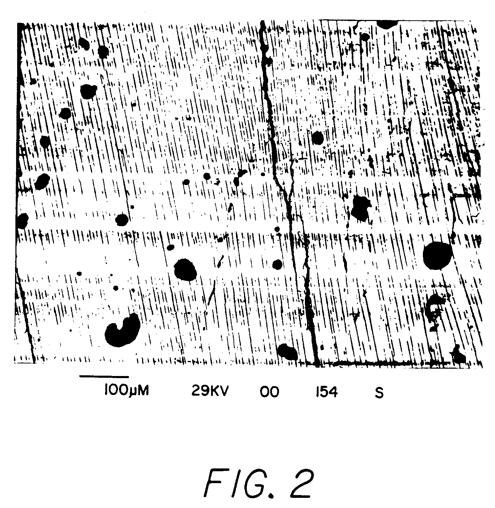

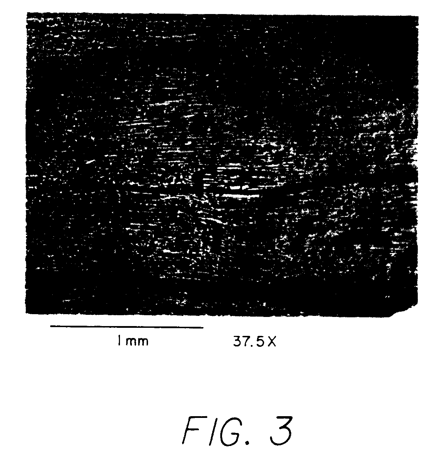

Shown in Figs. 1 and 2 are scanning electron microscopes at 300 and 150 magnifications, respectively, of the Y₁Ba₂Cu₃O_{6+δ} oxide composition wherein δ is between 0.7 and 1.0, prepared in accordance with this invention. The oxides prepared in accordance with this invention are comprised of long plate shaped grains typically between 10,000 and approximately 15,000 micrometers in length and approximately 20 micrometers in width. The plate axis coincides with the a-b direction in the superconducting layer of the orthorhombic phase. Fig. 3 illustrates the same composition viewed from an optical photomicrograph at 40 magnification. The parallel plates are characterized by a length of approximately 10,000 to 15,000 micrometers. The length of the grains greatly enhances the conductivity of current. The elongated grains of the oxide of this invention and the crystallographic alignment of the grains along its superconducting direction are highly beneficial for the flow of supercurrent thereby permitting higher J values for the superconductors than those of the prior art.

### EXAMPLE 1

In a jar mill were mixed 15 weight percent of Y₂O₃, 53 weight percent BaCO₃ and 32 weight percent CuO. The mixture was placed in an enclosed platinum container which was then heated at a rate of about 7°C per minute in air until a temperature of 940°C was obtained. The mixture was allowed to react at this temperature for about 24 hours. Bar samples of dimensions of 12.7 mm x 7.6 mm x 63.5 mm were obtained by cold pressing (at room temperature) the oxide mixture at an applied pressure of 7 x 10⁶ kg/m² (10,000 psi). The bars were then partially sliced into sections of thickness 2.5 mm. The samples were then heated in a preheated oven maintained at 1100°C for ten minutes.

This sample is then cooled rapidly to 1030°C and then cooled at a rate of 1°C per hour to 980°C. The sample was held at 980°C for eight hours and then cooled to 600°C at the rate of approximately 60°C per hour. This sample was then additionally cooled slowly to 400°C at a rate of approximately 30°C per hour. The sample was then annealed in oxygen for 12 hours each at 600, 500 and 400°C.

The current density, J at 77°K was tested. Current measurements are performed using a dc power supply of 120 A rating (H.P. model 6011 A) and a Keithley 181 nanovoltmeter. Pulse current up to 120 A was generated by a series of power transistors controlled by a pulse source. At a pulse of 1 msec, J was 75,000 amps/cm² at zero magnetic field and J was greater than 37,000 amps/cm² at a 0.6 T magnetic field. A J, for D.C. current, was measured in excess of 18,500 amp/cm² at 77°K and zero magnetic field.

### EXAMPLE 2

Samples prepared substantially as set forth in Example 1 were cut into dimensions 0.4 mm by 0.2-0.4 mm by 10 mm along the a-b plane. Measurements were performed at 77K using both continuous (H.P. model 6011A) and pulse dc currents, as set forth in Example 1. Pulse current density measurements were performed in order to minimize the effect of contact heating and give the true current carrying capacity of these samples. Pulse widths ranging from 1 to 10 ms were used in these measurements. Silver contacts and silver leads were used in these measurements and the samples were annealed in oxygen at 500°C with the contacts. The resistivity of these contacts at 77K is about 1»Ωcm². These samples were able to sustain up to 30 amps for varying times up to 150s. At these currents, the voltage drop across the sample was constant within 1»V/cm.

The current and the voltage drop across the sample were measured using a digital oscilloscope (Nicolet, model 2090). Currents up to 110 amps were used in these measurements. The noise level in the voltage drop signal across the sample was approximately 50»V which remained unchanged regardless of the current that passed through the specimen. The results of the measurements repeatedly exhibited by these samples are shown in Table I.

**TABLE I**

| Pulse width (ms) | Magnetic field T (G) | Current density (A/cm²) |
|---|---|---|
| 1 | 0 (0) | 75,000 |
| 10 | 0 (0) | 62,000 |
| 1 | 0.6 (6000) | 37,000 |
| ∞(dc) | 0 (0) | 18,500 |

As seen from Table I, in the absence of a magnetic field, the samples exhibits a current density in excess of 62,000 A/cm² when tested with a 10 ms pulse and in excess of 75,000 A/cm² when a 1 ms pulse was used. Samples tested in a magnetic field of 0.6T (6000 G) exhibited current density in excess of 37,000 A/cm² with a 1 ms pulse. In all these tests, the samples remained in the superconducting state until the end of the measurements and were not transformed to the normal state.

### EXAMPLE 3

A sample prepared substantially as set forth in Example 1 was cut into dimensions of 5 mm x 5 mm x 2 mm. The sample was cooled to approximately 77°K and placed on a glass disc. The sample was then exposed to a magnetic field of approximately 0.8T (8,000 Gauss) for approximately one minute. An entrapped field, determined by placing a Hall probe adjacent to the center of the sample, of 0.128T (1,280 Gauss) was recorded.

### EXAMPLE 4

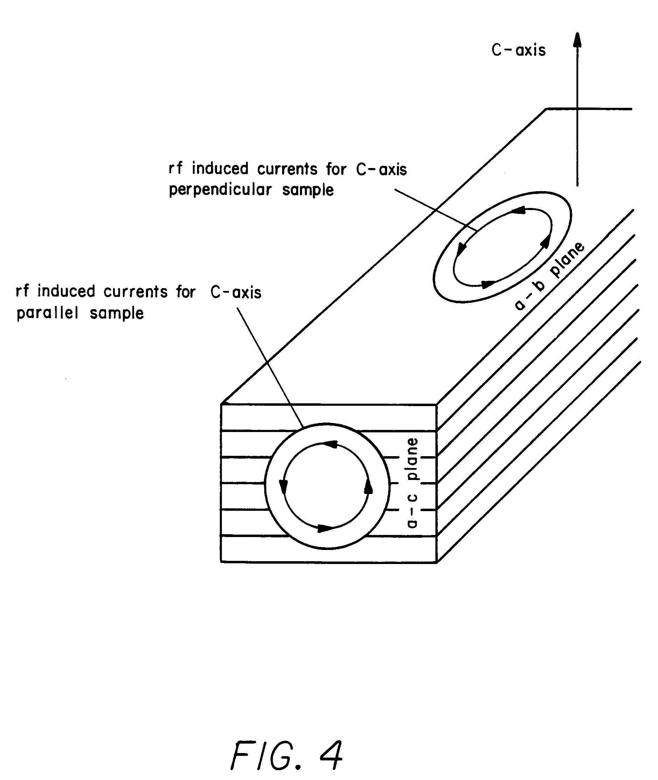

Measurements were performed on thin plates of the samples prepared substantially as set forth in Example 1. The thin plates were cut and polished with 0.3 micron sand paper. One sample (1 mm thick with 4 x 5 mm² area) was cut with the c-axis normal to its surface. This sample is referred to as the c-axis perpendicular sample. In this sample, the rf induced current flow is in the a-b plane. Figure 4 represents schematically the orientation of the grain-oriented sample to the rf current. The second sample (1 mm thick with 10 x 5mm²) had the c-axis parallel to the a-c plane. This sample is hereinafter called the c-axis parallel sample. For this sample, the induced rf current flow is in the plane perpendicular to the a-b plane.

Surface impedance measurements were performed in accordance with D. Kajfez, E. J. Hwan, IEEE Transaction on Microwave Theory and Techniques, Vol. Mtt-32, 666 (1984), in a TEₒ₁₁ mode cylindrical resonant copper cavity having an endplate of the superconductive material of Example 1. Aperture coupling was used through the side of the cavity body. Cavity cooling was by a helium closed cycle cryostat operating between 15 and 300°K.

The unloaded quality factor of the cavity was measured by Ginzton's impedance method as adapted for an HP8510 network analyzer with a 75-100 GHz test set. (See E.L. Ginzton "Microwave Measurements" McGraw-Hill, New York (1957).

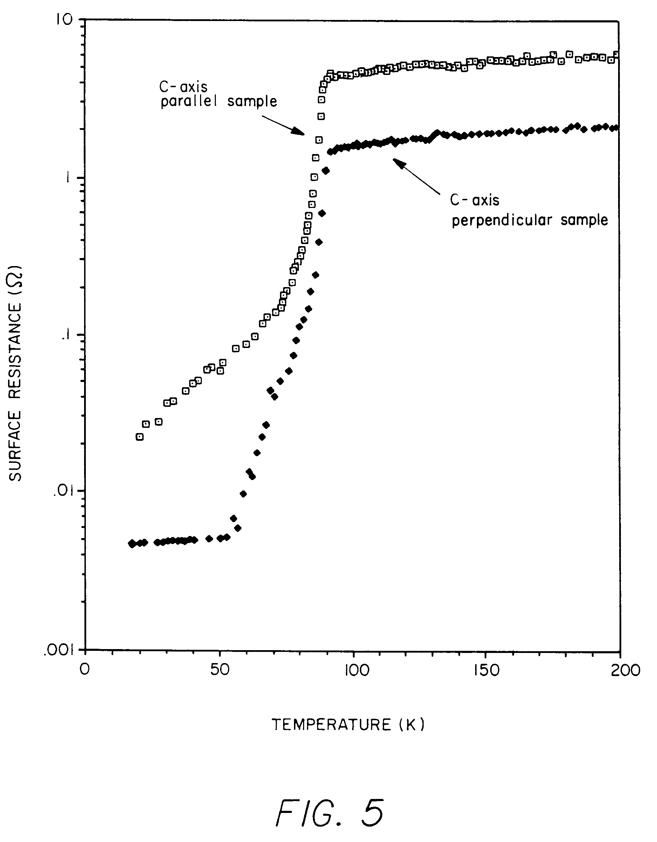

Figure 5 demonstrates the surface resistance versus temperatures for both sample orientations at 98 GHz. At 77 K the surface resistance at 98 GHz for the c-axis parallel sample is as high as 120 mΩ, while for the a-b plane the surface resistance is only 60 mΩ. At or below approximately 60°K, the surface area resistance in the a-b plane is approximately 5 milliohms.

As is readily apparent from the above description additional advantages and modifications will readily occur to one skilled in the art. The invention in its broader aspects is therefore not limited to the specific examples shown and described. Accordingly, departures may be made from the details shown in the example without departing from the spirit or scope of the disclosed general inventive concept.

## Claims

1. A bulk high-temperature superconductive composition comprising oriented grains of the formula
L₁Ba₂Cu₃O_{6+δ}
wherein L is a rare earth element and δ has a number value from about 0.5 to about 1.0 and further wherein at 77°K said bulk composition has a current density greater than 70,000 amps/cm² at zero magnetic field and a current density greater than 37,000 amps/cm² under a 0.6 T magnetic field.

2. A composition according to claim 1, wherein said composition further has at 77°K and zero magnetic field a D.C. current density greater than 18,500 amps/cm².

3. A composition according to claim 1 or 2, wherein the Bₜ of said composition when placed in an external applied magnetic field of approximately 0.8T (8,000 Gauss) is greater than or equal to 0.1T (1,000 Gauss).

4. A composition according to any one of claims 1 to 3, wherein the surface resistance of the a-b crystallographic basal plane of said composition approximately at or below 60°K at 98 GHz is less than or equal to 6 milliohms.

5. A composition according to any one of claims 1 to 4, wherein L is selected from scandium, yttrium, lanthanum, cerium, praseodymium, neodymium, samarium, europium, gadolinium, terbium, dysprosium, holmium, erbium, thulium, ytterbium, and lutetium.

6. A composition according to claim 5, wherein said rare earth element is yttrium.

7. A composition according to any one of claims 1 to 6, wherein the grains are stacked parallel to each other in the a-b crystallographic basal plane.

8. A composition according to any one of claims 1 to 7, wherein said grains have a perovskite structure.

9. A composition according to any one of claims 1 to 8, wherein the grains have a length between about 10 mm to about 15 mm; a width between about 5 mm to about 10 mm; and a thickness between about 16 »m to about 20 »m.

10. A composition according to any one of claims 1 to 9, wherein the grains are oriented by cooling a molten sample through its peritectic temperature.

11. A process for preparing a superconducting metal oxide complex comprising the steps of:
(a) sintering a compacted solid mass at a temperature between about 40°C to about 90°C below its melting point, wherein the solid mass is derived from compounds containing L, Ba, Cu and O, L being a rare earth element, and further wherein the amounts of said compounds are such as to yield the formula L₁Ba₂Cu₃O_{6+δ} wherein δ has a number value of from about 0.1 to about 1.0;
(b) heating the solid mass in a preheated chamber to a temperature of from about 80°C to about 190°C above its melting point for a time sufficient to partially melt and decompose said mass;
(c) rapidly cooling the mass to a temperature between about 10°C to 40°C above its melting point and then cooling the mass to a steady temperature between about 20°C to 40°C below its melting point at a rate of approximately 1°C/hour;
(d) maintaining the mass at said steady temperature for a time sufficient for the entire mass to resolidify; and
(e) annealing the resolidified mass in an oxygen containing atmosphere for a time sufficient for the requisite amount of oxygen to diffuse into the mass.

12. A process according to claim 11, wherein said compacted solid mass is obtained by
(1) mixing solid compounds containing L, Ba, Cu and O in amounts approximate to yield the formula L₁Ba₂Cu₃O_{6+δ} wherein δ has a number value of from about 0.1 to about 1.0;
(2) heating the solid compounds to a temperature between about 920°C to about 960°C for a time sufficient to react the compounds in the solid state;
(3) cooling the solid state reaction product to ambient temperature; and
(4) compacting the mixture into a solid mass by application of pressure.

13. A process according to claim 11 or 12, wherein the resolidified mass of step (d) is first cooled from said steady temperature to approximately 400°C below its melting point at the rate of approximately 60°C per hour; and is then additionally cooled to approximately 600°C below its melting point at the rate of approximately 30°C per hour.

14. A process according to any one of claims 11 to 13, wherein the resolidified mass is annealed in oxygen in a first temperature zone between about 580°C to about 620°C; a second temperature zone between about 480°C to about 520°C; and a third temperature zone between about 380°C to about 420°C.

15. A process according to any one of claims 11 to 14, wherein when L is yttrium the compacted solid mass is sintered at a temperature between about 920°C to 960°C.

16. A process according to any one of claims 11 to 15, wherein when L is yttrium the mass is rapidly cooled in step (c) to a temperature between 1,010°C to about 1,040°C.

17. A process according to any one of claims 11 to 16, wherein when L is yttrium the resolidified mass of step (d) is first cooled from said steady temperature to approximately 550°C to about 650°C at the rate of approximately 60°C per hour and then is additionally cooled to about 380°C to about 420°C at the rate of approximately 30°C per hour.

18. A product prepared in accordance with any one of claims 11 to 17 having a current density greater than 70,000 amps/cm² at 77°K and zero magnetic field.

19. A product prepared in accordance with claim 18, wherein L is selected from scandium, yttrium, lanthanum, cerium, praseodymium, neodymium, samarium, europium, gadolinium, terbium, dysprosium, holmium, erbium, thulium, ytterbium, and lutetium.

20. A product according to claim 19, wherein L is yttrium.

21. A method for conducting an electrical current within a conductor material without electrical resistive losses, comprising the steps of utilizing as the conductor material a metal oxide complex of the formula
L₁Ba₂Cu₃O_{6+δ}
wherein L is a rare earth element and δ has a number value from about 0.1 to about 1.0 and further wherein at 77°K, the current density of said composition is greater than 70,000 amps/cm² at zero magnetic field and the current density is greater than 37,000 amps/cm² under a 0.6 T magnetic field;
cooling said metal oxide complex to a temperature at or below that at which said metal oxide complex becomes superconductive; and
initiating a flow of electrical current within said metal oxide complex while maintaining said metal oxide complex at or below the temperature at which it becomes superconductive.

## Patentansprüche

1. Hochtemperatur-supraleitende Mengen-Zusammensetzung, umfassend ausgerichtete Körner der Formel
L₁Ba₂Cu₃O_{6+δ}
in der L ein Seltenerdelement ist und δ einen Zahlenwert von etwa 0,5 bis etwa 1,0 hat, und wobei bei 77 K die Mengen-Zusammensetzung bei einem Magnetfeld von Null eine Stromdichte von mehr als 70.000 A/cm² und bei einem Magnetfeld von 0,6 T eine Stromdichte von mehr als 37.000 A/cm² besitzt.

2. Zusammensetzung nach Anspruch 1, wobei bei 77 K und einem Magnetfeld von Null die Zusammensetzung eine Gleichstromdichte von mehr als 18.500 A/cm² hat.

3. Zusammensetzung nach Anspruch 1 oder 2, wobei das Bₜ der Zusammensetzung, befindet sie sich in einem externen Magnetfeld von etwa 0,8 T (8000 Gauß), größer oder gleich 0,1 T (1000 Gauß) ist.

4. Zusammensetzung nach einem der Ansprüche 1 bis 3, wobei bei 98 GHz und bei oder unter 60 K in der Zusammensetzung der Oberflächenwiderstand der kristallographischen Grundebene a-b kleiner oder gleich 6 mOhm ist.

5. Zusammensetzung nach einem der Ansprüche 1 bis 4, wobei L ausgewählt ist aus Scandium, Yttrium, Lanthan, Cer, Praseodym, Neodym, Samarium, Europium, Gadolinium, Terbium, Dysprosium, Holmium, Erbium, Thulium, Ytterbium und Lutetium.

6. Zusammensetzung nach Anspruch 5, wobei das Seltenerdelement Yttrium ist.

7. Zusammensetzung nach einem der Ansprüche 1 bis 6, wobei die Körner mit der kristallographischen Grundebene a-b zueinander parallel gestapelt sind.

8. Zusammensetzung nach einem der Ansprüche 1 bis 7, wobei die Körner eine Perowskit-Struktur haben.

9. Zusammensetzung nach einem der Ansprüche 1 bis 8, wobei die Körner eine Länge von etwa 10 bis etwa 15 mm, eine Breite von etwa 5 bis etwa 10 mm und eine Dicke von etwa 16 bis etwa 20 »m haben.

10. Zusammensetzung nach einem der Ansprüche 1 bis 9, wobei die Körner ausgerichtet sind durch Kühlen einer Schmelzprobe über deren Peritektikumtemperatur hinweg.

11. Verfahren zur Herstellung eines supraleitenden Metalloxidkomplexes, umfassend die Schritte:
(a) Sintern einer verdichteten festen Masse bei einer Temperatur von etwa 40 bis etwa 90°C unter ihrem Schmelzpunkt, wobei die feste Masse aus Verbindungen gewonnen wird, die L, Ba, Cu und O enthalten, wobei L ein Seltenerdelement ist, und die Verbindungsmengen zudem so sind, daß sie die Formel L₁Ba₂Cu₃O_{6+δ} ergeben, in der δ einen Zahlenwert von etwa 0,1 bis etwa 1,0 hat;
(b) Erwärmen der festen Masse in einer vorgewärmten Kammer auf eine Temperatur von etwa 80 bis etwa 190°C über ihren Schmelzpunkt, bis die Masse teilweise schmilzt und sich zersetzt;
(c) schnelles Abkühlen der Masse auf eine Temperatur zwischen etwa 10 und etwa 40°C über ihrem Schmelzpunkt und dann Abkühlen der Masse mit etwa 1°C pro Stunde auf eine konstante Temperatur von etwa 20 bis 40°C unter ihrem Schmelzpunkt;
(d) Halten der Masse bei der konstanten Temperatur bis die gesamte Masse wieder erstarrt; und
(e) Tempern der wiedererstarrten Masse in einer sauerstoffhaltigen Atmosphäre bis die erforderliche Menge an Sauerstoff in die Masse diffundiert ist.

12. Verfahren nach Anspruch 11, wobei die verdichtete Masse erhalten wird durch:
(1) Mischen von festen Verbindungen, die L, Ba, Cu und O in entsprechenden Mengen enthalten, daß sie die Formel L₁Ba₂Cu₃O_{6+δ} ergeben, wobei δ einen Zahlenwert von etwa 0,1 bis etwa 1,0 hat;
(2) Erwärmen der festen Verbindungen auf eine Temperatur von etwa 920 bis etwa 960°C, so daß die Verbindungen im Festzustand umgesetzt werden;
(3) Abkühlen des Produkts der Festphasereaktion auf Umgebungstemperatur; und
(4) Verdichten der Mischung unter Anwendung von Druck zu einer festen Masse.

13. Verfahren nach Anspruch 11 oder 12, wobei die wiedererstarrte Masse aus Schritt (d) zuerst mit etwa 60°C pro Stunde von der konstanten Temperatur auf etwa 400°C unter ihrem Schmelzpunkt gekühlt wird, und sie dann weiter mit etwa 30°C pro Stunde auf etwa 600°C unter ihrem Schmelzpunkt gekühlt wird.

14. Verfahren nach einem der Ansprüche 11 bis 13, wobei die wiedererstarrte Masse unter Sauerstoff bei etwa 580 bis etwa 620°C in einer ersten Temperaturzone, bei etwa 480 bis etwa 520°C in einer zweiten Temperaturzone und bei etwa 380 bis etwa 420°C in einer dritten Temperaturzone getempert wird.

15. Verfahren nach einem der Ansprüche 11 bis 14, wobei die verdichtete Feststoffmasse, ist L Yttrium, bei einer Temperatur von etwa 920 bis 960°C gesintert wird.

16. Verfahren nach einem der Ansprüche 11 bis 15, wobei die Masse im Schritt (c), ist L Yttrium, rasch auf eine Temperatur von 1010 bis etwa bis 1040°C abgekühlt wird.

17. Verfahren nach einem der Ansprüche 11 bis 16, wobei, ist L Yttrium, die erneut verfestigte Masse aus Schritt (d) zuerst mit etwa 60°C pro Stunde von der konstanten Temperatur auf etwa 550 bis etwa 650°C und dann weiter mit etwa 30°C pro Stunde auf etwa 380 bis etwa 420°C abgekühlt wird.

18. Erzeugnis, hergestellt nach einem der Ansprüche 11 bis 17, das bei 77 K und einem Magnetfeld von Null eine Stromdichte von mehr als 70.000 A/cm² besitzt.

19. Erzeugnis, hergestellt nach Anspruch 18, wobei L ausgewählt ist aus Scandium, Yttrium, Lanthan, Cer, Praseodym, Neodym, Samarium, Europium, Gadolinium, Terbium, Dysprosium, Holmium, Erbium, Thulium, Ytterbium und Lutetium.

20. Erzeugnis nach Anspruch 19, wobei L Yttrium ist.

21. Verfahren zum Leiten von Strom in einem elektrisch verlustfreien, widerstandslosen Leitermaterial, umfassend die Schritte: Verwenden eines Metalloxidkomplexes der Formel
L₁Ba₂Cu₃O_{6+δ}
als Leitermaterial, wobei L ein Seltenerdelement ist und δ einen Zahlenwert von etwa 0,1 bis etwa 1,0 hat, und wobei zudem bei 77 K und einem Magnetfeld von Null die Stromdichte der Zusammensetzung größer ist als 70.000 A/cm² und bei einem Magnetfeld von 0,6 T die Stromdichte größer ist als 37.000 A/cm²;
Kühlen des Metalloxidkomplexes auf oder unter eine Temperatur, bei der der Metalloxidkomplex supraleitend wird; und
Erregen eines elektrischen Stromflusses in dem Metalloxidkomplex, wobei der Metalloxidkomplex auf oder unter der Temperatur gehalten wird, bei der er supraleitend wird.

## Revendications

1. Composé compact supraconducteur à haute température à grains orientés, de formule
L₁Ba₂CU₃0₆+δ
caractérisé en ce que L est une terre rare et δ a une valeur numérique comprise entre 0,5 environ et 1,0 environ, et en ce que, en outre, ledit composé compact présente, à 77 K, une densité de courant supérieure à 70 000 A/cm² dans un champ magnétique d'intensité nulle, et une densité de courant supérieure à 37 000 A/cm² dans un champ magnétique de 0,6 T.

2. Composé selon la revendication 1, caractérisé en ce que ledit composé présente, en outre, à 77 K et dans un champ magnétique d'intensité nulle, une densité de courant en CC supérieure à 18 500 A/cm².

3. Composé selon l'une ou l'autre des revendications 1 et 2, caractérisé en ce que le Bₜ dudit composé, lorsque celui-ci est soumis à un champ magnétique extérieur de 0,8 T (8 000 G) environ, est supérieur ou égal à 0,1 T (1 000 G).

4. Composé selon l'une quelconque des revendications 1 à 3, caractérisé en ce que la résistance de surface du plan cristallographique de base a-b dudit composé, à 98 GHz et à une température approximativement égale ou inférieure à 60 K, est inférieure ou égale à 6mΩ.

5. Composé selon l'une quelconque des revendications 1 à 4, caractérisé en ce que L est choisi parmi le groupe comprenant le scandium, l'yttrium, le lanthane, le cérium, le praséodyme, le néodyme, le samarium, l'europium, le gadolinium, le terbium, le dysprosium, l'holmium, l'erbium, le thulium, l'ytterbium et le lutécium.

6. Composé selon la revendication 5, caractérisé en ce que ladite terre rare est l'yttrium.

7. Composé selon l'une quelconque des revendications 1 à 6, caractérisé en ce que les grains sont empilés parallèlement entre eux dans le plan cristallographique de base a-b.

8. Composé selon l'une quelconque des revendications 1 à 7, caractérisé en ce que lesdits grains ont la structure de la perovskite.

9. Composé selon l'une quelconque des revendications 1 à 8, caractérisé en ce que les grains ont une longueur comprise entre 10 mm environ et 15 mm environ, une largeur comprise entre 5 mm environ et 10 mm environ et une épaisseur comprise entre 16 »m environ et 20 »m environ.

10. Composé selon l'une quelconque des revendications 1 à 9, caractérisé en ce que les grains sont orientés par refroidissement d'un échantillon fondu en passant par sa température péritectique.

11. Procédé de fabrication d'un complexe d'oxyde métallique supraconducteur caractérisé en qu'il comporte les étapes suivantes :
(a) frittage d'une masse solide compactée à une température inférieure d'environ 40°C à 90°C à son point de fusion, la masse solide étant dérivée de composés contenant L, Ba, Cu et O, L étant une terre rare, et en ce que, en outre, les quantités desdits composés sont appropriées pour obtenir la formule L₁Ba₂CU₃0₆+δ, dans laquelle δ a une valeur numérique comprise entre 0,1 environ et 1,0 environ ;
(b) chauffage de la masse solide dans une chambre préchauffée à une température supérieure d'environ 80°C à 190°C environ à son point de fusion, pendant un laps de temps suffisant pour fondre partiellement et décomposer ladite masse ;
(c) refroidissement rapide de la masse à une température supérieure d'environ 10°C à 40°C à son point de fusion, puis refroidissement de la masse jusqu'à une température d'équilibre, inférieure d'environ 20°C à 40°C à son point de fusion, à une vitesse de 1°C/h environ ;
(d) maintien de la masse à ladite température d'équilibre pendant un laps de temps suffisant pour que toute la masse soit resolidifiée ; et
(e) revenu de la masse resolidifiée dans une atmosphère contenant de l'oxygène, pendant un laps de temps suffisant pour que la quantité requise d'oxygène diffuse dans la masse.

12. Procédé selon la revendication 11, caractérisé en ce que ladite masse solide compactée est obtenue par :
(1) mélange de composés solides contenant L, Ba, Cu et O en quantités appropriées pour obtenir la formule L₁Ba₂CU₃0₆+δ, dans laquelle δ a une valeur numérique comprise entre 0,1 environ et 1,0 environ ;
(2) chauffage des composés solides à une température comprise entre 920°C environ et 960°C environ, pendant un laps de temps suffisant pour que les produits réagissent à l'état solide ;
(3) refroidissement du produit de réaction à l'état solide jusqu'à la température ambiante ; et
(4) compactage du mélange sous forme d'une masse solide par application d'une pression.

13. Procédé selon l'une ou l'autre des revendications 11 et 12, caractérisé en ce que la masse resolidifiée à l'étape (d) est tout d'abord refroidie depuis ladite température d'équilibre jusqu'à une température inférieure d'environ 400°C à son point de fusion, à la vitesse de 60°C/h environ, et refroidie, en plus, à une température inférieure de 600°C environ à son point de fusion, à la vitesse de 30°C/h environ.

14. Procédé selon l'une quelconque des revendications 11 à 13, caractérisé en ce que la masse resolidifiée est recuite dans l'oxygène dans une première plage de température comprise entre 580°C environ et 620°C environ ; dans une deuxième plage de température comprise entre 480°C environ et 520°C environ ; et dans une troisième plage de température comprise entre 380°C environ et 420°C environ.

15. Procédé selon l'une quelconque des revendications 11 à 14, caractérisé en ce que L est l'yttrium, et en ce que la masse solide compactée est frittée à une température comprise entre 920°C et 960°C environ.

16. Procédé selon l'une quelconque des revendications 11 à 15, caractérisé en ce que L est l'yttrium et en ce que la masse est refroidie rapidement dans l'étape (c) jusqu'à une température comprise entre 1 010°C environ et 1 040°C environ.

17. Procédé selon l'une quelconque des revendications 11 à 16, caractérisé en ce que L est l'yttrium et en ce que la masse resolidifiée à l'étape (d) est tout d'abord refroidie depuis ladite température d'équilibre jusqu'à une température comprise entre 550°C environ et 650°C environ, à une vitesse de 60°C/h environ, et refroidie, en plus, à une température comprise entre 380°C environ et 420°C environ, à la vitesse de 30°C/h environ.

18. Produit préparé conformément à l'une quelconque des revendications 11 à 17, caractérisé en ce que sa densité de courant est supérieure à 70 000 A/cm², à 77 K et dans un champ magnétique d'intensité nulle.

19. Produit préparé conformément à la revendication 18, caractérisé en ce que L est choisi parmi le groupe comprenant le scandium, l'yttrium, le lanthane, le cérium, le praséodyme, le néodyme, le samarium, l'europium, le gadolinium, le terbium, le dysprosium, l'holmium, l'erbium, le thulium, l'ytterbium et le lutécium.

20. Produit selon la revendication 19, caractérisé en ce que L est l'yttrium.

21. Procédé pour faire passer un courant électrique à l'intérieur d'un matériau conducteur sans pertes par résistance électrique, comprenant les étapes suivantes :
utilisation, en tant que matériau conducteur, d'un complexe d'oxyde métallique de formule
L₁Ba₂CU₃0₆+δ
dans laquelle L est une terre rare et δ a une valeur numérique comprise entre 0,1 environ et 1,0 environ, ledit composé compact présentant, en outre, une densité de courant à 77 K supérieure à 70 000 A/cm² dans un champ magnétique d'intensité nulle, et une densité de courant supérieure à 37 000 A/cm² dans un champ magnétique de 0,6 T ;
refroidissement dudit complexe d'oxyde métallique jusqu'à une température égale ou supérieure à celle à laquelle ledit complexe d'oxyde métallique devient supraconducteur ; et
la production d'un courant électrique à l'intérieur dudit complexe d'oxyde métallique tout en maintenant ledit complexe d'oxyde métallique à une température égale ou inférieure à la température à laquelle il devient supraconducteur.
